# DEMANDE DE BREVET EUROPEEN

(11) **EP 4 580 052 A1**
(43) Date de publication de la demande: **02.07.2025**
(21) Numéro de dépôt: 24223433.4
(22) Date de dépôt: 27.12.2024
(51) Int. Cl.: H03F 1/52, H03F 3/195, H03G 11/00, H03G 11/02

(54) **LIMITEUR RADIOFRÉQUENCE**

(30) Priorité: 28.12.2023 FR 2315421
(71) Demandeur: THALES, 92190 Meudon (FR)
(72) Inventeur: DINARI, Mehdi, 78851 Élancourt Cedex (FR); CAMIADE, Marc, 91140 Villebon-sur-Yvette (FR); PLAZE, Jean-Philippe, 78851 Élancourt Cedex (FR); OUARCH-PROVOST, Zineb, 91140 Villebon-sur-Yvette (FR)
(74) Mandataire: Lavoix

(57) **Abrégé**

L'invention se rapporte à un limiteur radiofréquence, comprenant un port d'entrée (IN), un port de sortie (OUT), une pluralité de transistors (T1...TN) connectés en parallèle entre le port d'entrée (IN) et le port de sortie (OUT), les transistors (T1...TN) étant configurés pour être polarisés uniquement entre leur grille et leur source au cours du fonctionnement du limiteur, et une pluralité de self-inductances (L1... LN), connectées en série entre le port d'entrée (IN) et le port de sortie (OUT), en alternance avec chacun des transistors (T1...TN), chaque grille de transistor étant connectée à une source de tension (VLim) par l'intermédiaire d'une résistance de réglage (R_{Lim1}... R_{LimN}), caractérisé en ce qu'une diode (Det1...DetN) est connectée entre chaque drain et chaque résistance de réglage (R_{Lim1}... R_{LimN}).

## Description

### Domaine technique

L'invention se rapporte au domaine des limiteurs de puissance radiofréquence, utilisés notamment dans les modules d'émission/réception (E/R) radiofréquences de systèmes aéroportés.

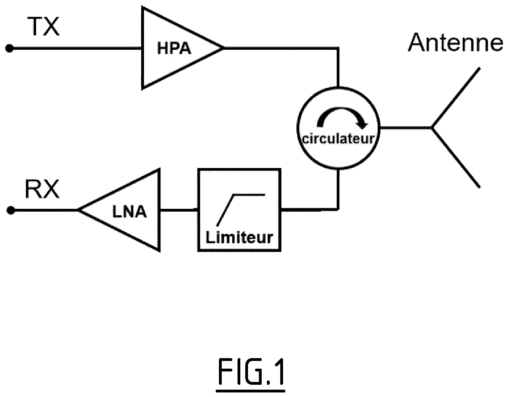

Le limiteur de puissance est un dispositif dont l'objectif est d'écrêter sa puissance de sortie en présence de niveaux de puissance d'entrée élevés. Généralement situé dans les chaines de réception, devant des éléments sensibles tels que les amplificateurs faible bruit (LNA - Low Noise Amplifier), son utilisation est devenue indispensable pour se prémunir d'éventuelles agressions (intentionnelles ou non) de sources électromagnétiques de plus en plus puissantes (figure 1). Les LNA sont généralement réalisés à base de technologies du type AsGa, Si ou plus récemment GaN. Les technologies AsGa et Si permettent d'obtenir des niveaux de bruit réduits mais n'admettent pas des niveaux de puissance trop élevés (environ 0,5 W).

Les limiteurs sont en général réalisés à partir de diodes PIN et/ou Shottky. Ces diodes ont l'avantage de présenter un faible coût tout en offrant une bonne tenue en puissance.

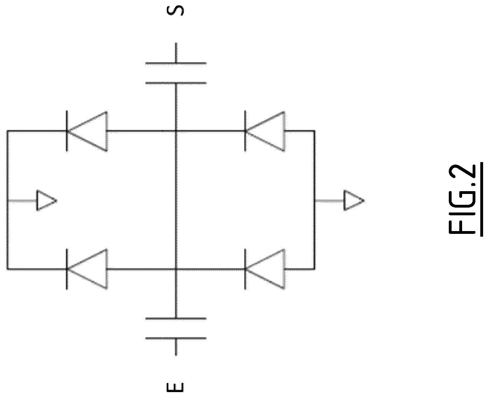

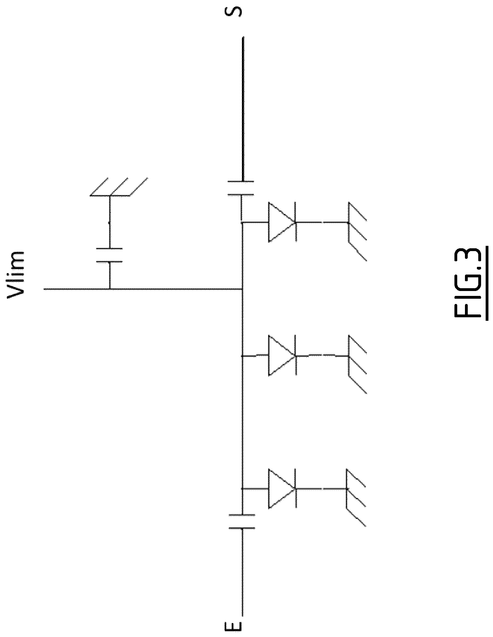

Les structures de limiteurs majoritairement employées et utilisant des diodes PIN et/ou Shottky sont généralement basées sur des architectures de diodes « tête-bêche » (figure 2) afin d'écrêter la demi-alternance positive et la demi-alternance négative du signal, ou sur des architectures de diodes parallèles (figure 3). Dans les deux cas, ces architectures utilisent la non-linéarité des diodes pour réfléchir et donc écrêter le signal RF à partir d'un certain niveau de puissance.

Le problème est que leur intégration devient de plus en plus difficile dans les équipements du fait des contraintes de miniaturisation. Bien que disponibles dans certaines technologies de circuits intégrés MMIC (Monolithic Microwave Integrated Circuit), ces technologies ne permettent pas l'intégration des limiteurs avec d'autres fonctions comme les LNA, ce qui réduit de fait la possibilité de compacter les récepteurs.

[1] présente une solution pour répondre aux besoins cités précédemment. Il décrit un limiteur MMIC réalisé en technologie GaN à partir de transistors à effet de champ non polarisés entre leur drain et leur source, appelés FET froids (FET pour « Field Effect Transistor »). Ces transistors sont placés en parallèle entre l'entrée RF et la sortie RF du limiteur et en alternance avec des self-inductances (placées en série entre l'entrée RF et la sortie RF).

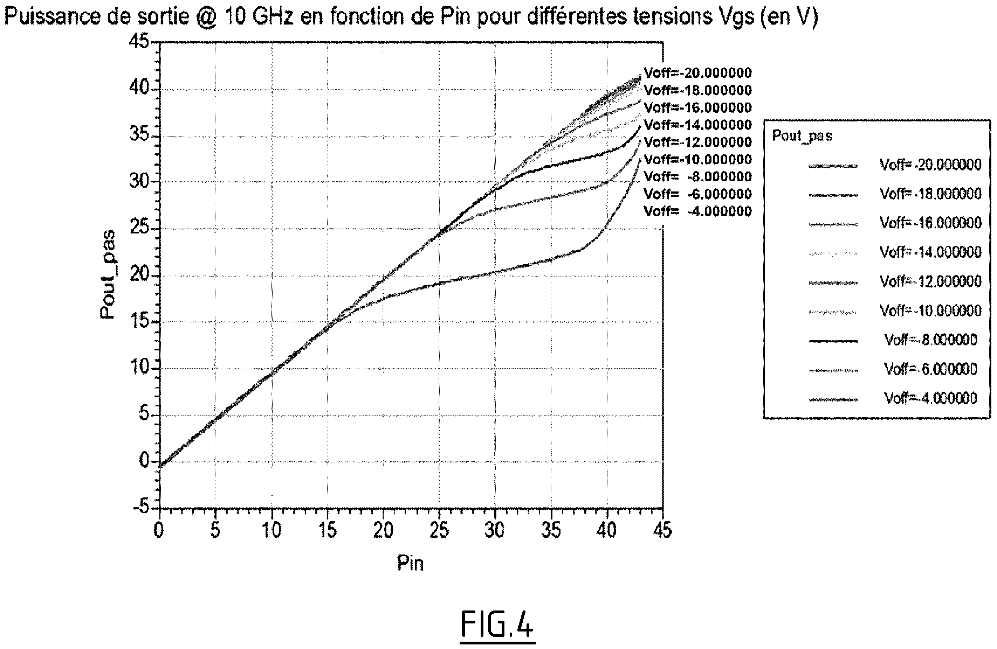

Bien que remplissant sa fonction en mode TX (mode émission, mode dans lequel le limiteur est en atténuation maximum afin d'isoler le LNA vis-à-vis de la voie TX), la structure décrite dans [1] a pour inconvénient de ne pas suffisamment écrêter sa puissance de sortie en mode RX (mode réception dans lequel le limiteur doit à la fois protéger le LNA et présenter des pertes d'insertion les plus faibles possibles pour garantir les performances de la chaine RX). En effet, comme l'illustre la figure 4, en mode RX, lorsque la puissance d'entrée Pin augmente (en présence d'une agression, par exemple), la puissance de sortie Pout n'atteint pas un palier, et continue d'augmenter. Le niveau de limitation n'est pas suffisant. En effet, il convient de ne pas dépasser les 20 dBm en sortie, afin de ne pas endommager les amplificateurs faible bruit de la chaîne de réception qui seraient réalisés en AsGa.

Il existe donc un besoin pour obtenir un limiteur radiofréquence qui offre une bonne tenue en puissance, tout en ayant une bonne compacité.

### Résumé de l'invention

Un objet de l'invention est donc un limiteur radiofréquence, comprenant un port d'entrée, un port de sortie, une pluralité de transistors connectés en parallèle entre le port d'entrée et le port de sortie, les transistors étant configurés pour être polarisés uniquement entre leur grille et leur source au cours du fonctionnement du limiteur, et une pluralité de self-inductances, connectées en série entre le port d'entrée et le port de sortie, en alternance avec chacun des transistors, chaque grille de transistor étant connectée à une source de tension par l'intermédiaire d'une résistance de réglage, une diode étant connectée entre chaque drain et chaque résistance de réglage.

Avantageusement, l'anode de la diode est connectée entre deux self-inductances, et la cathode de la diode est connectée à la résistance de réglage.

Avantageusement, la source de tension est configurée pour appliquer une tension proche de la tension de pincement des transistors au niveau de la grille de chaque transistor.

Avantageusement, une résistance de protection est connectée directement, d'une part, à la grille du transistor et, d'autre part, à la diode et à la résistance de réglage.

Avantageusement, le limiteur est intégré en technologie MMIC de forte puissance à base de Nitrure de Gallium (GaN).

Avantageusement, les résistances de réglage n'ont pas toutes la même valeur.

Avantageusement, la valeur de la résistance de réglage la plus proche du port d'entrée est supérieure aux valeurs des autres résistances de réglage.

L'invention se rapporte également à un module d'émission/réception, comprenant un limiteur radiofréquence précité.

L'invention se rapporte également à l'utilisation du limiteur radiofréquence précité ou du module d'émission/réception précité, comme plot d'atténuation variable commandable en faisant varier la tension générée par la source de tension.

Avantageusement, la plage de tension varie entre la tension de pincement des transistors et 0 V.

### Description des figures

D'autres caractéristiques, détails et avantages de l'invention ressortiront à la lecture de la description faite en référence aux dessins annexés donnés à titre d'exemple.
La figure 1, déjà décrite, illustre le schéma de principe d'un module émission réception intégrant un limiteur.
La figure 2, déjà décrite, illustre le schéma de principe d'un limiteur à diodes tête-bêche.
La figure 3, déjà décrite, illustre le schéma de principe d'un limiteur à diodes en parallèle.
La figure 4, déjà décrite, illustre la réponse en puissance du limiteur tel que décrit dans [1] pour plusieurs niveaux d'atténuation.
La figure 5 illustre le schéma de principe de l'invention.
La figure 6 illustre le schéma équivalent du limiteur en mode RX.
La figure 7 illustre le schéma équivalent du limiteur en mode TX.
La figure 8 illustre l'évolution de la puissance de sortie ainsi que de la réponse en transmission en fonction de la puissance d'entrée du limiteur en mode RX.
La figure 9 illustre la réponse en transmission et les coefficients de réflexion en entrée/sortie à faible niveau de puissance RF du limiteur en mode RX.
La figure 10 illustre la réponse en transmission et coefficients de réflexion en entrée/sortie à faible niveau de puissance RF du limiteur en mode TX.
La figure 11 illustre l'évolution de la puissance de sortie ainsi que de la réponse en transmission en fonction de la puissance d'entrée du limiteur en mode TX.
La figure 12 illustre l'évolution de la puissance de sortie ainsi que de la réponse en transmission en fonction de la puissance d'entrée, pour une seule fréquence et pour différents niveaux de commande VLim.

### Description détaillée de l'invention

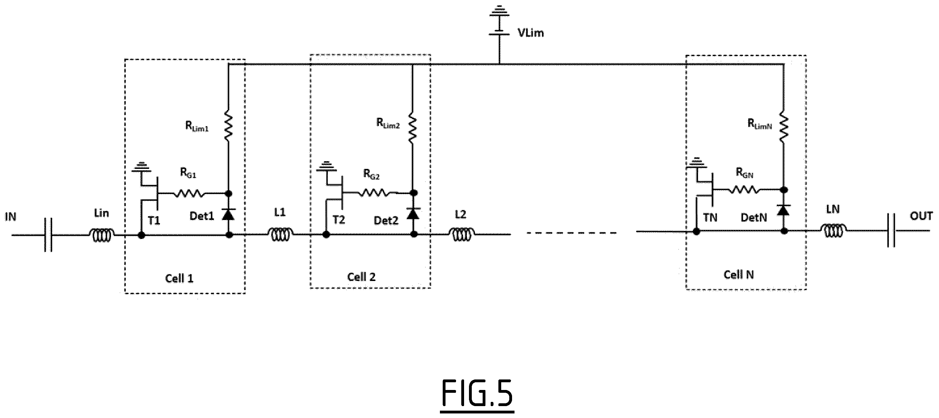

Sur la figure 5, le port d'entrée IN est un point de connexion qui permet de recevoir le signal en sortie du circulateur. Le port de sortie OUT est un autre point de connexion qui permet de mettre le signal limité à disposition des amplificateurs faible bruit LNA de la voie de réception.

Le limiteur comprend une pluralité de cellules (Cell1...CellN) connectées en parallèle, ainsi qu'une pluralité de self-inductances (L1...LN) connectées en série, en alternance avec les cellules. Le nombre de cellules résulte d'un compromis entre le niveau de limitation recherché et les pertes d'insertions qui peuvent être acceptées.

Chaque cellule comprend un transistor (T1...TN) qui est dit « froid », car polarisé uniquement entre la grille et la source lors du fonctionnement du limiteur. En effet, aucune tension de polarisation n'est vue par le drain. La source de chaque transistor est connectée à un potentiel de référence (masse). Comme l'illustre la figure 5, le drain de chaque transistor est connecté directement à une des self-inductances.

La grille de chaque transistor est connectée au potentiel de commande VLim dont la valeur va moduler le niveau d'atténuation. Des résistances de protection (R_{G1}...R_{GN}) peuvent être connectées directement à la grille du transistor (T1...TN), pour isoler le circuit de commande du signal hyperfréquence.

Dans chaque cellule, une diode de détection (Det1...DetN) est connectée à la source de tension (VLim) par l'intermédiaire d'une résistance de réglage (R_{Lim1}...R_{LimN}) qui permet de jouer sur le niveau de limitation de la fonction, comme indiqué ci-après. Ainsi, chaque diode de détection (Det1... DetN) est connectée entre le drain du transistor et une résistance de réglage (R_{Lim1}... R_{LimN}). De préférence, l'anode de la diode (Det1... DetN) est connectée entre deux self-inductances (L1...LN), et la cathode de la diode (Det1...DetN) est connectée à la grille du transistor (T1...TN) (éventuellement par l'intermédiaire de la résistance de protection (R_{G1}...R_{GN})), et à la résistance de réglage (R_{Lim1}... R_{LimN}).

Les self-inductances et condensateurs en extrémité de limiteur, immédiatement adjacents au port d'entrée et au port de sortie, sont illustrés afin de tenir compte des fils de câblage en entrée et en sortie, qui peuvent introduire des inductances et capacités parasites.

A bas niveau de puissance et pour une tension VLim permettant de bloquer les transistors et les diodes de détection (VLim=Vp tension de pincement), le limiteur est équivalent à une ligne de transmission.

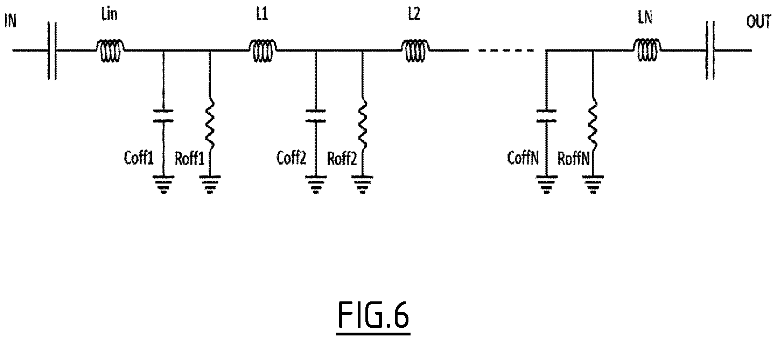

Chaque cellule est alors équivalente à une résistance Roff (résistance à l'origine des pertes d'insertion) et une capacité Coff en parallèle (capacité parasite limitant la fréquence de fonctionnement), comme l'illustre la figure 6. Le choix de la taille des transistors des différentes cellules va conditionner la valeur de la capacité Coff et par conséquent la fréquence de coupure du limiteur.

Avec l'augmentation du niveau de Pin d'entrée, les diodes de détection vont se mettre à conduire et vont venir modifier la polarisation de grille des transistors. La tension vue par chacune des grilles sera égale à VLim - RLim.I_{Diode} avec VLim la tension de commande et I_{Diode} le courant traversé par chaque diode.

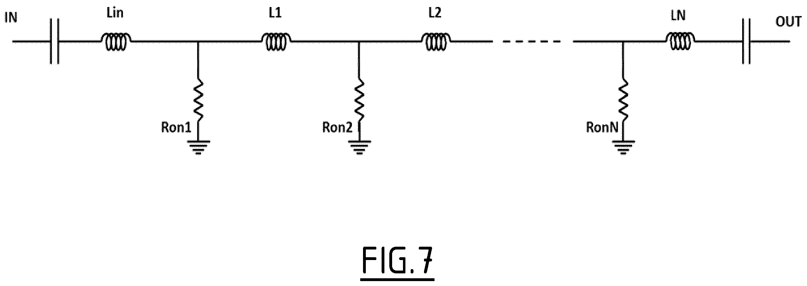

Les transistors vont alors progressivement passer d'un état bloqué (haute impédance) vers un état passant (basse impédance) faisant ainsi augmenter les pertes d'insertion, et donnant une allure de compression au limiteur, semblable à ce qui est obtenu sur un amplificateur. Le modèle équivalent du limiteur en fin plage de variation du Pin d'entrée est alors équivalent à celui décrit dans le schéma de la figure 7.

Selon un mode de réalisation préférentiel, les résistances de réglage (R_{Lim1}... R_{LimN}) n'ont pas toutes la même valeur, ce qui permet de déclencher le changement d'état des cellules à différents instants.

De façon plus préférentielle, la valeur de la résistance de réglage R_{Lim1} la plus proche du port d'entrée IN est supérieure aux valeurs des autres résistances de réglage (R_{Lim2}...R_{LimN}). En effet, la première cellule Cell1 est attaquée par la puissance la plus élevée. Il est donc avantageux d'avoir une valeur de résistance plus élevée pour cette cellule.

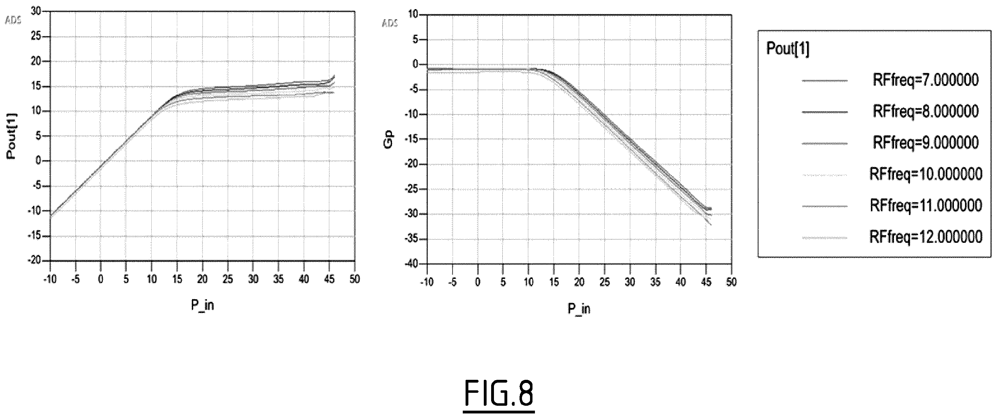

Cet effet est illustré par la figure 8, qui présente respectivement l'évolution des pertes d'insertion et de la puissance de sortie Pout en fonction de la puissance d'entrée Pin. Ces performances sont obtenues pour une tension de commande VLim=Vp, correspondant à un fonctionnement en mode RX (mode passant) et pour des fréquences de signal RF variant entre 6 et 12 GHz.

On peut constater une très nette amélioration du niveau de limitation comparé à ce qui était obtenu jusqu'à maintenant avec le limiteur tel que décrit dans [1] (cf. figure 4). Le niveau de la puissance de sortie reste en effet inférieur à 16 dBm pour des niveaux de puissance d'entrée pouvant aller jusqu'à 46 dBm.

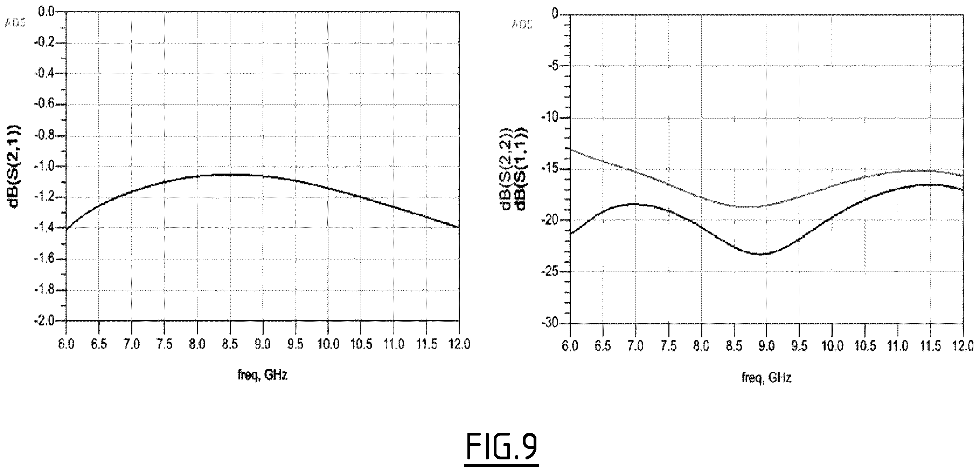

La figure 9 illustre la réponse en transmission et les coefficients de réflexion en entrée/sortie à faible niveau de puissance RF du limiteur lorsque le limiteur est en mode RX. L'architecture du limiteur permet d'avoir une réponse sensiblement identique à celle d'une ligne en transmission en deçà de la fréquence de coupure de la structure, avec des pertes en transmission inférieures à 1,4 dB sur 6 GHz de bande, ainsi qu'une excellente adaptation aux accès RF dans cette bande de fonctionnement.

Il est rappelé qu'en mode RX (mode réception), le limiteur doit présenter des pertes d'insertion les plus faibles possibles pour garantir les performances de la chaine de réception, tout en protégeant les amplificateurs faible bruit LNA en cas d'agression.

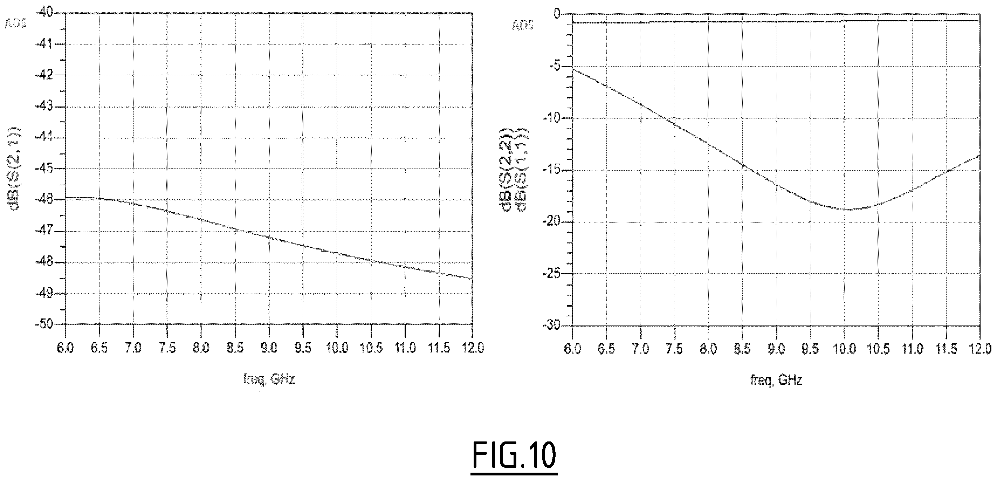

La figure 10 présente la réponse en transmission ainsi que les coefficients de réflexion en entrée/sortie RF à bas niveau (dans la zone de fonctionnement linéaire) du limiteur lorsqu'il est en mode TX (atténuation maximum). Le niveau d'atténuation est d'environ 48 dB ce qui permet de bien isoler des amplificateurs faible bruit LNA de la chaine RX vis-à-vis des amplificateurs HPA de la chaine TX lorsque ces derniers émettent.

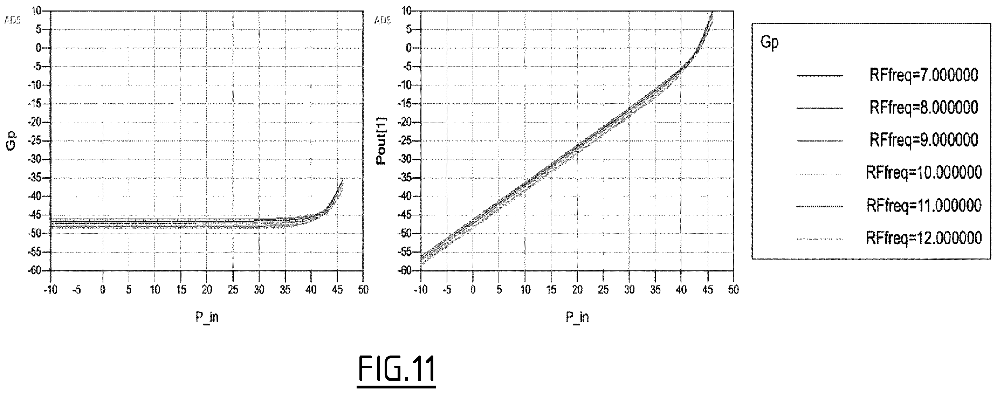

La figure 11 illustre l'évolution des pertes d'insertion ainsi que la puissance de sortie du limiteur selon l'invention en fonction de la puissance d'entrée Pin en mode TX et pour des fréquences comprises entre 6 et 12 GHz. Ces résultats sont obtenus pour une tension VLim appliquée entre la grille et la source des transistors T1...TN égale à 0 V. La courbe de gain illustre le fait que l'atténuation est constante, indépendamment de la fréquence ou de la puissance d'entrée.

Les courbes présentées montrent que le limiteur remplit parfaitement son rôle de limitation, que ce soit en mode TX ou RX, et pour des niveaux de puissance d'entrée bien plus élevés que ceux présentés en [1].

Comme indiqué précédemment, la tension de commande VLim permet de faire passer les transistors d'un mode haute impédance (mode RX, VLim=Vp, atténuation minimum) à un mode basse impédance (mode TX, VLim=0V, atténuation maximum), et réciproquement. L'invention permet aussi d'utiliser le limiteur radiofréquence comme un plot d'atténuation variable en appliquant une tension VLim comprise entre 0 et Vp.

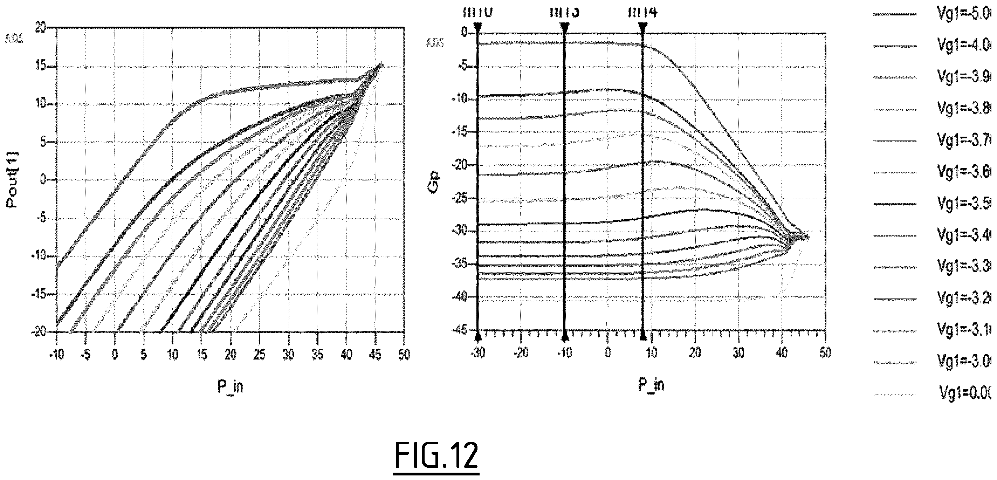

La figure 12 présente l'évolution de la puissance de sortie en fonction de la puissance d'entrée (figure de gauche) ainsi que la réponse en transmission (gain, figure de droite) du limiteur selon l'invention pour différents niveaux de tension VLim correspondant à différents niveaux d'atténuation.

Le fait que le limiteur puisse intégrer cette fonctionnalité apporte plusieurs avantages. Premièrement, cela permet de faire l'économie d'un atténuateur variable qu'il faudrait potentiellement ajouter, ce qui augmente le niveau d'intégration. Deuxièmement, cela améliore les performances de la chaine RX car cette fonctionnalité supplémentaire permet de faire l'économie des pertes d'insertion d'un composant supplémentaire.

Ainsi, il est possible de concevoir un module d'émission/réception dans lequel le limiteur radiofréquence et le réseau d'amplificateurs faible bruit sont réalisés sur un seul MMIC.

Le limiteur radiofréquence selon l'invention peut être intégré en technologie MMIC de forte puissance à base de Nitrure de Gallium (GaN), ce qui permet d'offrir une bonne tenue en puissance et un fort niveau d'intégration.

L'invention se rapporte également à l'utilisation du limiteur radiofréquence précité, comme plot d'atténuation variable commandable en faisant varier la tension VLim générée par la source de tension.

### Référence citée

[1] FR 3 013 536 B1

## Revendications

1. Limiteur radiofréquence, comprenant un port d'entrée (IN), un port de sortie (OUT), une pluralité de transistors (T1...TN) connectés en parallèle entre le port d'entrée (IN) et le port de sortie (OUT), les transistors (T1...TN) étant configurés pour être polarisés uniquement entre leur grille et leur source au cours du fonctionnement du limiteur, et une pluralité de self-inductances (L1...LN), connectées en série entre le port d'entrée (IN) et le port de sortie (OUT), en alternance avec chacun des transistors (T1...TN), chaque grille de transistor étant connectée à une source de tension (VLim) par l'intermédiaire d'une résistance de réglage (R_{Lim1}... R_{LimN}), **caractérisé en ce qu'**une diode (Det1... DetN) est connectée entre chaque drain et chaque résistance de réglage (R_{Lim1}...R_{LimN}).

2. Limiteur radiofréquence selon la revendication 1, dans lequel l'anode de la diode (Det1... DetN) est connectée entre deux self-inductances (L1...LN), et la cathode de la diode (Det1... DetN) est connectée à la résistance de réglage (R_{Lim1}...R_{LimN}).

3. Limiteur radiofréquence selon l'une des revendications précédentes, dans lequel la source de tension (VLim) est configurée pour appliquer une tension proche de la tension de pincement des transistors (T1...TN) au niveau de la grille de chaque transistor (T1...TN).

4. Limiteur radiofréquence selon l'une des revendications précédentes, dans lequel une résistance de protection (R_{G1}...R_{GN}) est connectée directement, d'une part, à la grille du transistor (T1...TN) et, d'autre part, à la diode (Det1... DetN) et à la résistance de réglage (R_{Lim1}... R_{LimN}).

5. Limiteur radiofréquence selon l'une des revendications précédentes, dans lequel il est intégré en technologie MMIC de forte puissance à base de Nitrure de Gallium (GaN).

6. Limiteur radiofréquence selon l'une des revendications précédentes, dans lequel les résistances de réglage (R_{Lim1}... R_{LimN}) n'ont pas toutes la même valeur.

7. Limiteur radiofréquence selon la revendication 6, dans lequel la valeur de la résistance de réglage (R_{Lim1}) la plus proche du port d'entrée (IN) est supérieure aux valeurs des autres résistances de réglage (R_{Lim2}...R_{LimN}).

8. Module d'émission/réception, comprenant un limiteur radiofréquence selon l'une des revendications précédentes.

9. Utilisation du limiteur radiofréquence selon l'une des revendications 1 à 7 ou du module d'émission/réception selon la revendication 8, comme plot d'atténuation variable commandable en faisant varier la tension générée par la source de tension (VLim).

10. Utilisation du limiteur radiofréquence selon la revendication précédente, dans laquelle la plage de tension varie entre la tension de pincement des transistors et 0 V.
